# EUROPÄISCHE PATENTANMELDUNG

(11) **EP 1 284 503 A1**
(43) Veröffentlichungstag der Anmeldung: **19.02.2003**
(21) Anmeldenummer: 01810772.2
(22) Anmeldetag: 13.08.2001
(51) Int. Cl.: H01L 23/473

(54) **Leistungshalbleitermodul**

(71) Anmelder: ABB RESEARCH LTD., 8050 Zürich (CH)
(72) Erfinder: Knapp, Wolfgang, 5430 Wettingen (CH)
(74) Vertreter: ABB Patent Attorneys

(57) **Zusammenfassung**

Eine zwischen einem der elektrischen Anschlüsse (8) und einer der Hauptelektroden (21) des Halbleiterchips (2) angeordnete Kühlstruktur (3) ist gasdurchlässig ausgebildet. Die direkt auf der Hauptelektrode (21) angeordnete Kühlstruktur (3) ist im Bereich des elektrischen Anschlusses an der Ausströmöffnung (6) eines ein Kühlgas führenden Kanals (9) angeordnet. Das Kühlgas wird dabei von aussen durch einen Einlass (5) in den Kühlgaskanal (9) des Halbleitermoduls gepresst.

Die vom Halbleiterelement erzeugte Wärme wird in der direkt auf der Hauptelektrode des Halbleiterchips angebrachten Kühlstruktur vom expandierenden Gas abgebaut. Das erfindungsgemässe Halbleitermodul kommt somit ohne externe Kühlelemente wie beispielsweise wassergekühlte Kühlkörper aus.

## Beschreibung

### Technisches Gebiet

Die vorliegende Erfindung bezieht sich auf das Gebiet der Leistungselektronik. Sie betrifft ein Leistungshalbleitermodul nach dem Oberbegriff des Patentanspruchs 1.

### Stand der Technik

Zur Verminderung von mechanischen Spannungen zwischen zwei Materialien mit unterschiedlichen thermischen Ausdehnungskoeffizienten werden zwischen den Materialien Pufferelemente angeordnet.
Derartige Pufferelemente werden in Hochleistungs-Halbleiterbauelementen eingesetzt, um thermisch induzierte mechanische Spannungen zwischen einem Halbleiterelement und einer plattenförmigen Metallelektrode zu minimieren. Mechanische Spannungen führen zu einer Ermüdung der Verbindungsschichten zwischen dem Halbleiterelement und den Metallelektroden, beeinträchtigen somit das elektrische Verhalten des Halbleiterbauelementes und können zu dessen Ausfall führen.

In James Burgess et al., "Solder Fatigue Problems in a Power Package", IEEE Transactions on components, hybrids and manufacturing technology, vol. chmt-7, no. 4, December 1984, Seite 405-410, wird ein derartiges Pufferelement, hier "Structured Copper" genannt, beschrieben. Dieses Pufferelement aus Kupfer besteht aus einer Vielzahl aneinandergereihter Kupferdraht-Stückchen, welche sich unabhängig voneinander bewegen können. Werden sie als Bindeglied zwischen zwei Materialien mit unterschiedlichen Wärmeausdehnungskoeffizienten eingesetzt, so ermöglicht ihre freie Bewegungsfähigkeit, dass sie mechanische Spannungen aufnehmen, ohne diese an die Verbindungspartner zu übertragen.

In Homer H. et al, "Structured copper: a pliable high conductance material for bonding to silicon power devices", IEEE Transactions on components, hybrids and manufacturing technology, vol. chmt-6, no. 4, December 1983, Seite 460-466, wird beschrieben, wie derartige "Structured Copper"-Elemente hergestellt werden. Ein dünner, beschichteter Kupferfaden, typischerweise mit einem Durchmesser von einem Viertel Millimeter, wird um zwei beabstandet angeordnete Stäbe gewickelt. Die so entstandene Spule wird in ein Kupferrohr eingeschoben, welches durch eine Drahtziehbank gezogen wird. Anschliessend wird das Rohr gemeinsam mit der Spule mehrere Male gepresst, bis eine Wicklungsdichte von bis zu 1600 Drähte pro Quadratzentimeter erreicht wird. Zum Schluss wird das Rohr in Scheiben geschnitten. Es wird eine Scheibe erhalten, bestehend aus losen Kupferdrahtstückchen, welche von einem Kupferring zusammengehalten werden. Soll der Ring entfernt werden, müssen die Kupferdrahtstückchen an einem Ende miteinander verbunden, beispielsweise zusammengelötet werden.

Ein derartiges "Structured Copper"-Element ist auch in US-A-4'385'310 beschrieben.

Dank der guten thermischen Leitfähigkeit eignen sich derartige ,Structured Copper'-Element nicht nur als elektrische, sondern auch als thermische Leiter. Dies wird in herkömmlichen Halbleitermodulen genutzt, um die in den Halbleiterchips entstehende Wärme durch die dünnen Drähte zu ausserhalb der Halbleitermodule angeordneten Kühlelementen zu führen.

### Kurze Darstellung der Erfindung

Die Aufgabe der vorliegenden Erfindung besteht darin, ein Leistungshalbleitermodul der eingangs genannten Art zu schaffen, welches ohne ausserhalb des Moduls angeordnete Kühlelemente auskommt.

Die Aufgabe wird erfindungsgemäss gelöst mit einem Leistungshalbleitermodul mit den Merkmalen des Patentanspruchs 1.

Eine zwischen einem der elektrischen Anschlüsse und einer der Hauptelektroden des Halbleiterchips angeordnete Kühlstruktur ist gasdurchlässig ausgebildet. Die direkt auf der Hauptelektrode des Halbleiterchips angeordnete Kühlstruktur ist im Bereich des elektrischen Anschlusses an der Ausströmöffnung eines ein Kühlgas führenden Kühlgaskanals angeordnet. Das Kühlgas wird dabei von aussen durch einen Einlass im Gehäuse in den Kühlgaskanal des Halbleitermoduls gepresst.

Die vom Halbleiterelement erzeugte Wärme wird in der direkt auf der Hauptelektrode des Halbleiterchips angebrachten Kühlstruktur vom expandierenden Gas abgebaut. Das Gas strömt durch die Kühlstruktur und dehnt sich dabei unter Aufnahme von Wärmeenergie aus.

Die Wärme wird dadurch in der unmittelbaren Nähe des Halbleiterchips abgebaut. Das erfindungsgemässe Halbleitermodul kommt somit ohne externe Kühlelemente wie beispielsweise wassergekühlte Kühlkörper aus. Dadurch lässt sich die Gesamtgrösse der Module reduzieren.

In einer vorteilhaften Ausführungsform des erfindungsgemässen Halbleitermoduls ist die Kühlstruktur als ein Bündel aus geraden, parallel zueinander angeordneten Drähten ausgebildet. Diese sogenannte strukturierte Schicht aus einzelnen Drähten weist eine grosse Gesamtoberfläche auf. Das expandierende Gas kühlt die Oberflächen der die Wärme des Halbleiters führenden Drähte.

In einer weiteren vorteilhaften Ausführungsform des erfindungsgemässen Halbleitermoduls ist die Kühlstruktur als ein offenzelliger Schaum oder ein poröser Sinterkörper aus einem elektrisch leitfähigen Material ausgebildet. Diese Kühlstrukturen weisen ebenfalls eine sehr grosse Gesamtoberfläche auf.

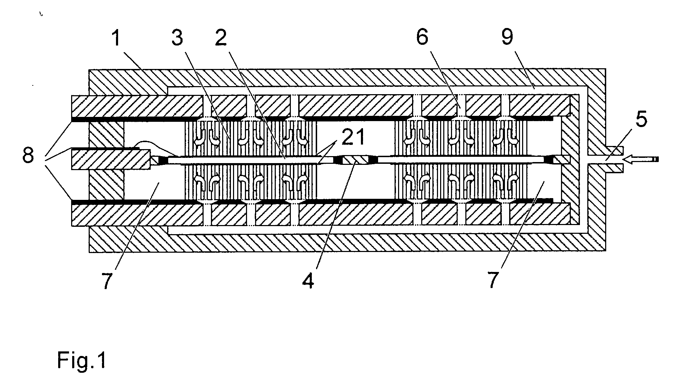

### Kurze Beschreibung der Zeichnung

Die Figur zeigt einen Querschnitt durch ein Leistungshalbleitermodul nach der Erfindung. Die Darstellung ist nicht massstabgetreu.

### Weg zur Ausführung der Erfindung

In der Figur ist im Querschnitt ein bevorzugtes Ausführungsbeispiel für ein Hochleistungshalbleitermodul nach der Erfindung gezeigt. In einem Gehäuse 1 sind zwei Halbleiterchips 2 angeordnet. Es können auch eine andere Anzahl von Halbleiterchips in einem gemeinsamen Gehäuse angeordnet sein. Die Halbleiterchips sind elektrisch parallelgeschaltet wodurch sich die für hohe Ströme benötigte aktive Halbleiterfläche als Summe mehrerer Einzelflächen zusammensetzt.

Die Halbleiterchips 2 umfassen auf beiden Hauptflächen, als auf der Unter- und Oberseite, je eine metallisierte Hauptelektrode 21, welche mit Anschlüssen 8 in elektrischem Kontakt stehen. Die Anschlüsse 8 sind ins Innere des Modulgehäuses hineingeführt und beispielsweise als Leiterplatte (PCB, Printed Circuit Board) ausgebildet.

Ebenfalls dargestellt in der Figur ist der normalerweise gebondete Gateanschluss zur Ansteuerung der Halbleiterchips. Der mittlere der drei auf der linken Seite dargestellten, in das Modulgehäuse hineingeführten Anschlüsse ist über ein Drahtstück mit dem Steueranschluss des einen Halbleiterchips verbunden.

Die Halbleiterchips 2 werden von zwischen den Hauptelektroden 21 und den Anschlüssen 8 angeordneten Kühlstrukturen 3 getragen. Seitlich werden die Halbleiterchips von einer Kunststoffhalterung4 stabilisiert.

Die Kühlstrukturen 3 weisen eine grosse Oberfläche auf. Dafür eignen sich die oben beschriebenen ,Structured Copper'-Elemente ebenso, wie etwa offenzelliger Schaum oder Sinterkörper aus leitfähigem Material, bsp. Aluminium.

Die ,Structured Copper'-Elemente bestehen aus einer Vielzahl aneinandergereihter Kupferdraht-Stückchen, welche sich unabhängig voneinander bewegen können. Ihre freie Bewegungsfähigkeit ermöglicht, dass sie, beispielsweise thermisch bedingte, mechanische Spannungen aufnehmen, ohne diese an die Verbindungspartner zu übertragen. Im erfindungsgemässen Leistungshalbleitermodul dienen diese ,Structured Copper'-Elemente also sowohl als elektrische und thermische Leiter wie auch als Pufferelement zur Aufnahme von mechanischen Spannungen.

Auf der rechte Seite des dargestellten Modulgehäuses ist ein Einlass 5 angeordnet, durch den komprimiertes Gas ins Innere des Halbleitermoduls gepresst wird. In der in der Figur dargestellten Ausführungsform des erfindungsgemässen Leistungshalbleitermoduls führen Kühlgaskanäle 9 vom Einlass 5 nach oben und nach unten, also auf beide Seiten der Halbleiterchips2 . In die Leiterplatten der elektrischen Anschlüsse 8 sind im Bereich der Kühlstrukturen 3 Aussparungen 6 eingelassen, welche als Ausströmöffnungen für das komprimierte Gas vorgesehen sind. In der dargestellten Ausführungsform sind pro Kühlstruktur drei Ausströmöffnungen 6 vorgesehen. Pro Kühlstruktur kann jedoch auch nur eine Ausströmöffnung oder jede beliebige Anzahl Ausströmöffnungen angeordnet sein. Entsprechend kann auch die Grösse der Ausströmöffnungen variieren, insbesondere können pro Kühlstruktur verschieden grosse Ausströmöffnungen vorgesehen sein.

Das komprimierte Gas wird durch die Kühlgaskanäle 9 und die Ausströmöffnungen 6 in die Kühlstrukturen 3 gepresst. Darin expandier das Gas und kühlt dadurch die von der Wärme der Halbleiterchips erhitzte Oberfläche der Kühlstruktur. Das Gas strömt seitlich weg und wird durch Auslassöffnungen 7 aus dem Gehäuse geführt

Neben gasförmigen können auch flüssige Kühlmedien verwendet werden.

Auf die Art und interne Struktur der Halbleiterchips selbst ist in den bisherigen Erläuterungen nicht eingegangen worden. Sofern das Modul insgesamt ein IGBT Modul darstellt, ist die interne Struktur entsprechend diejenige eines IGBT oder einer Diode. Das erfindungsgemässe Leistungshalbleitermodul kann aber auch andere Halbleiterbauelemente enthalten.

### Bezugszeichenliste

- 1: Gehäuse
- 2: Halbleiterchip
- 21: Hauptelektroden
- 3: Kühlstruktur
- 4: Halterung
- 5: Einlass für komprimiertes Gas
- 6: Ausströmöffnungen
- 7: Auslass für expandiertes Gas
- 8: Elektrische Anschlüsse, Leiterplatten
- 9: Kühlgaskanal

## Patentansprüche

1. Leistungshalbleitermodul, umfassend in einem gasdichten Gehäuse (1) mindestens einen Halbleiterchip (2) mit zwei Hauptelektroden (21), mindestens zwei von aussen in das Gehäuse hineingeführte elektrische Anschlüsse (8) sowie mindestens eine Kühlstruktur (3),
**dadurch gekennzeichnet, dass**
- die Kühlstruktur (3) gasdurchlässig ausgebildet ist, und dass
- die Kühlstruktur (3) als elektrisch leitende Verbindung zwischen einem der elektrischen Anschlüsse (8) und einer der Hauptelektroden (21) angeordnet ist, wobei die Kühlstruktur (3)
- einerseits direkt auf der Hauptelektrode (21) und
- andererseits, im Bereich des elektrischen Anschlusses (8), am Auslass (6) eines ein Kühlgas führenden Kanals (9) angeordnet ist.

2. Leistungshalbleitermodul nach Anspruch 1, **dadurch gekennzeichnet, dass**
- die beiden Hauptelektroden (21) auf gegenüberliegenden Hauptflächen des Halbleiterchips (2) angeordnet sind, und dass
- an beiden Hauptelektroden (21) jeweils eine Kühlstruktur (3) angeordnet ist.

3. Leistungshalbleitermodul nach einem der Ansprüche 1 oder 2, **dadurch gekennzeichnet, dass**
- die Kühlstruktur (3) als ein Bündel aus geraden, parallel zueinander und im wesentlichen vom Auslass (6) zum Halbleiterchip (2) verlaufend angeordneten Drähten aus Metall ausgebildet ist.

4. Leistungshalbleitermodul nach einem der Ansprüche 1 oder 2, **dadurch gekennzeichnet, dass**
- die Kühlstruktur (3) aus einem elektrisch leitfähigen, offenzelligen Schaum oder einem elektrisch leitfähigen Sinterkörper gefertigt ist.
